Europäisches Patentamt

European Patent Office

Office européen des brevets

(11) Publication number : **0 519 692 A2**

(12) # EUROPEAN PATENT APPLICATION

(21) Application number : 92305529.7

(22) Date of filing : 17.06.92

(51) Int. Cl.⁵ : **H01L 21/84,** H01L 21/336

(30) Priority : **17.06.91 JP 144914/91**

(43) Date of publication of application :
**23.12.92 Bulletin 92/52**

(84) Designated Contracting States :
**DE FR GB NL**

(71) Applicant : **SHARP KABUSHIKI KAISHA**
**22-22 Nagaike-cho Abeno-ku**
**Osaka 545 (JP)**

(72) Inventor : **Mitani, Yasuhiro**
**2-338-11, Takawashi**
**Habikino-shi, Osaka (JP)**
Inventor : **Ikubo, Katsumasa**
**2613-1-906, Ichinomoto-cho**
**Tenri-shi, Nara-ken (JP)**
Inventor : **Tanaka, Hirohisa**
**55-2-1-603, Higashi Ando, Ando-cho**
**Ikoma-gun, Nara-ken (JP)**
Inventor : **Morimoto, Hiroshi**
**1-14-9, Sakuragaoka, Kanmaki-cho**
**Kitakatsuragi-gun, Nara-ken (JP)**

(74) Representative : **Brown, Kenneth Richard et al**
**R.G.C. Jenkins & Co. 26 Caxton Street**
**London SW1H 0RJ (GB)**

(54) **Thin film transistor and method for manufacturing the same.**

(57)   A thin film transistor comprising : a gate electrode formed on a substrate ; a gate insulating film covering said gate electrode ; a semiconductor layer forming a channel region on said gate insulating film ;

a channel protective layer formed on the semiconductor layer in the vicinity of the center thereof ; and

a drain electrode and a source electrode extending in the right and left directions along said semiconductor layer surface from the right and left sides of said channel protective layer, respectively,

wherein said channel protective layer has inclined right and left side surfaces, and the semiconductor layer is in contact with said source and drain electrodes and is doped with an impurity just under the foot of the inclined side surfaces of said channel protective layer in order to prevent a leak and to provide ohmic contact and preparation method.

FIG. 2

EP 0 519 692 A2

## BACKGROUND OF THE INVENTION

### 1. Field of the Invention

The present invention relates to a thin film transistor formed as a switching element on an active matrix substrate, which is used in a shutter array, a liquid crystal display or the like.

### 2. Description of the Related Art

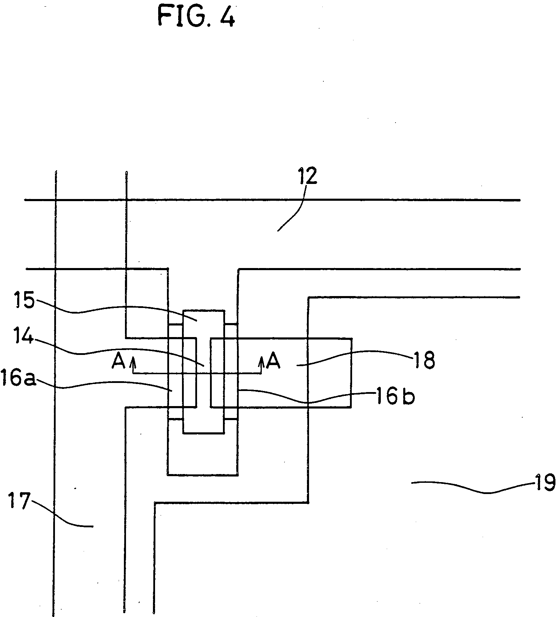

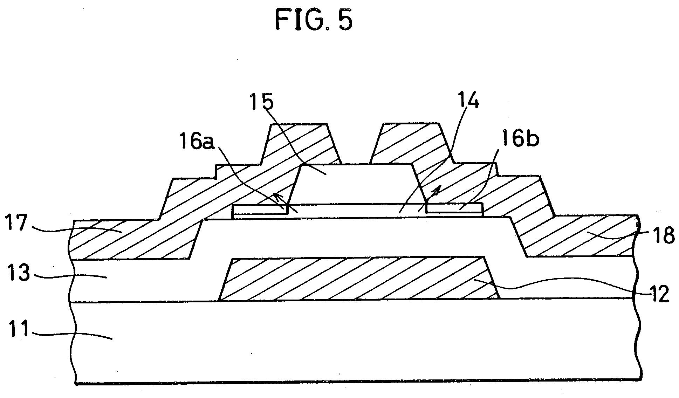

Fig. 4 (plan view) and Fig. 5 (sectional view taken along a line A-A in Fig. 4) show a conventional thin film transistor. The thin film transistor comprises a gate electrode 12 and a gate insulating film 13 formed on, for example a transparent insulating substrate 11 in this order, and a semiconductor layer 14 and contact layers ($n^+$a-Si) 16a and 16b, which comprise amorphous silicon (a-Si), formed on the gate insulating film 13 above the gate electrode 12. As shown in Fig. 5, the semiconductor layer 14 and the contact layers 16a and 16b are formed so as to be larger than the semiconductor layer 14 and a part where the semiconductor layer 14 is to be left is covered with a channel protective film 15. Then, ion implantation is performed thereon, whereby a part which is not covered with the channel protective film 15 becomes the contact layers 16a and 16b.

Next, as shown in Fig. 5, a source electrode 17 and a drain electrode 18 are formed so as to be separated on the channel protective film 15 and the drain electrode 18 is electrically connected to a pixel electrode 19 (referring to Fig. 4).

However, the conventional thin film transistor shown in Figs. 4 and 5 has the following problem. That is, as shown in Fig. 5, the semiconductor layer 14 is close to the source electrode 17 only through one end of the channel protective film 15 and the semiconductor layer 14 is also close to the drain electrode 18 only through the other end of the channel protective film 15. Therefore, a leak is generated between the source electrode 17 and the drain electrode 18, so that they are not likely to normally operate. A place where the leak is generated is shown by an arrow in the figure. Since the contact layer (a-Si) hardly exists at this part, a leak can not be prevented.

Especially, although an active matrix type display of large capacity and high density such as an HD (High Definition) TV or a graphic display which uses a liquid crystal or electroluminescence has recently been developed and put to practical use, when the conventional thin film transistor is used in the above display, a leak current of approximately $10^{-9}$ to $10^{-11}$A is generated and then it sometimes can not be used therein.

Referring to the above problem, it is proposed that a thin film transistor comprises a contact layer, in which an impurity is distributed with low concentration, provided between the semiconductor layer and the source and drain electrodes in order to prevent the leak current from being generating. However, a yield or reliability of the transistor is deteriorated because the number of processing and the number of photomasks are increased. According to a method for manufacturing this transistor, a non-linear current generated by contact between electrodes at the source and drain regions and a semiconductor layer of the thin film transistor and an OFF current using a hole as a carrier are removed, whereby the channel of the transistor is shortened (Japanese Opened Patent No. 4566/1991).

## SUMMARY OF THE INVENTION

The present invention provides a thin film transistor and its manufacturing method capable of preventing a leak from being generated and also capable of being used in an active matrix type display using a large current flow.

According to the thin film transistor of the present invention, a gate insulating film is formed so as to cover a gate electrode formed on a substrate, a semiconductor layer forming a channel region is deposited on the gate insulating film, a channel protective layer is formed in the vicinity of the center of the semiconductor layer, and a drain electrode and a source electrode are extended in the right and left directions along the semiconductor layer surface from the right and left sides of the channel protective layer, respectively. The channel protective layer has inclined surfaces on its right and left sides and an impurity for preventing a leak current and providing ohmic contact is doped in the semiconductor layer region which is in contact with the source and drain electrodes and in the semiconductor region just under the foot of the inclined surface of the channel protective layer.

In addition, according to the method for forming the thin film transistor of the present invention, there is formed a gate electrode on a substrate, a gate insulating film covering the gate electrode, a semiconductor layer forming a channel region on the gate insulating film, and a cone-shaped channel protective layer provided on the semiconductor layer in the vicinity of the center thereof and comprising inclined right and left side surfaces; an ion doped region is formed in the exposed semiconductor layer and in the semiconductor layer under the foot of the inclined surface of the channel protective layer; and drain and source electrodes extending in the right and left directions along the exposed semiconductor layer from the right and left sides of the channel protective layer, respectively.

## BRIEF DESCRIPTION OF THE DRAWINGS

Fig. 1 is a plan view showing a part of a thin film transistor in accordance with the present invention;

Fig. 2 is a sectional view taken along a line B-B of Fig. 1;

Fig. 3 is a sectional view showing ion implantation in accordance with the preset invention;

Fig. 4 is a plan view showing a part of a conventional thin film transistor;

Fig. 5 is a sectional view taken along a line A-A of Fig. 4; and

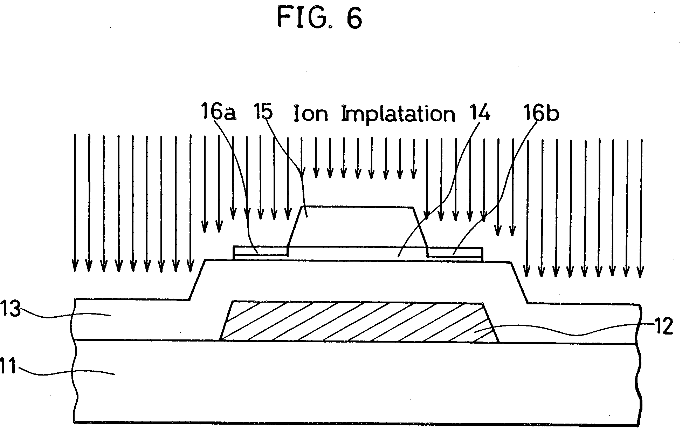

Fig. 6 is a sectional view showing conventional ion implantation.

## DETAILED DESCRIPTION OF THE PREFERRED EMBODIMENTS

According to the present invention, a channel protective film is formed such that its side surface are inclined, a contact layer is formed from the lower part of the inclined surface of the channel protective film over an exposed surface of the semiconductor layer and a semiconductor layer is formed at a part other than the contact layer under the channel protective film. More specifically, the contact layer also exists under the channel protective film. Therefore, there is the contact layer having a sufficient thickness between the semiconductor layer and the source electrode, and the semiconductor layer and the drain electrode. Thus, a distance between the semiconductor layer and the source electrode and a distance between the semiconductor layer and the drain electrode are increased by the contact layers. As a result, a leak current can be prevented from being generated between the source electrode and the drain electrode.

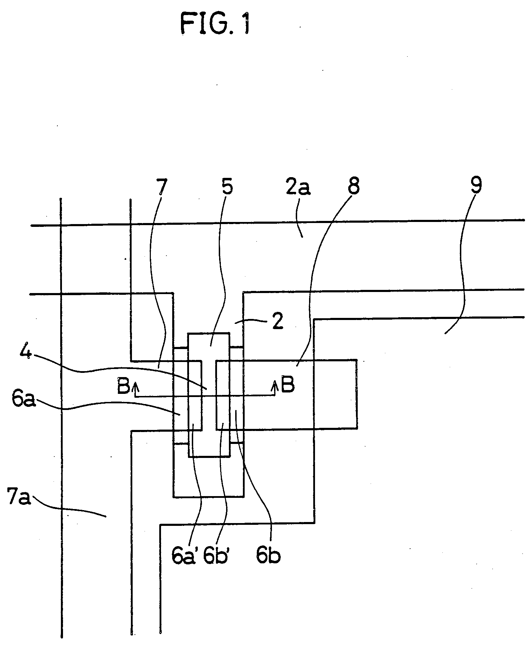

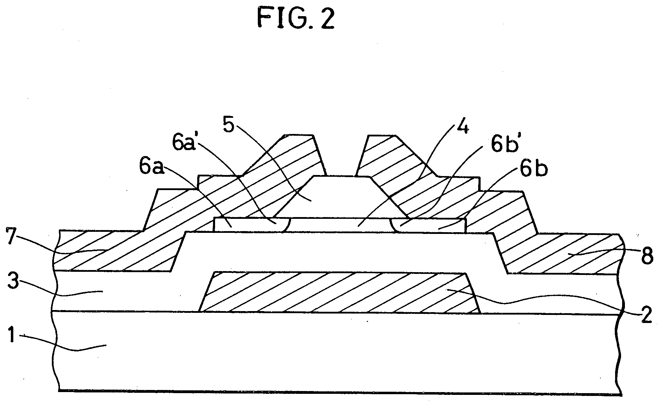

Fig. 1 is a plan view showing a part of a thin film transistor of the present invention and Fig. 2 is a sectional view taken along a line B-B of Fig. 1. In the thin film transistor, a gate electrode 2 is formed on a transparent insulating substrate 1 such as glass (CORNING 7059) or quartz glass. More specifically, the gate electrode 2 is formed by depositing a single-layer or multiple-layer metal having a thickness of 2,000 to 4,000 Å such as Ta, Ti, Al, or Cr on the transparent insulating substrate 1 by sputtering and patterning it. At this time, a gate bus line 2a having the gate electrode 2 which diverges midway is formed (referring to Fig. 1).

A gate insulating film 3 and a semiconductor layer 4' are formed on the gate electrode 2 on the substrate 1. More specifically, the gate insulating film 3 is formed by depositing $SiN_x$, $Ta_2O_5$, $SiO_3$, $Al_2O_3$ or the like by a thickness of 2,000 to 5,000 Å by a plasma CVD method. Then, a semiconductor layer 4' is formed thereon. The semiconductor layer 4' comprises contact layers 6a and 6b and contact layers 6a' and 6b' in which an impurity is implanted with low concentration. These five layers are formed by varying the degree of ion implantation into the semiconductor layer 4'.

In order to form an n type semiconductor, Group (III) atom, such as P, As, Sb or Pt is implanted. Alternatively, in order to form a p type semiconductor, Group (V) atom such as B is implanted. The ion concentration at this time is approximately $10^{10}$ to $10^{17}$ /cm².

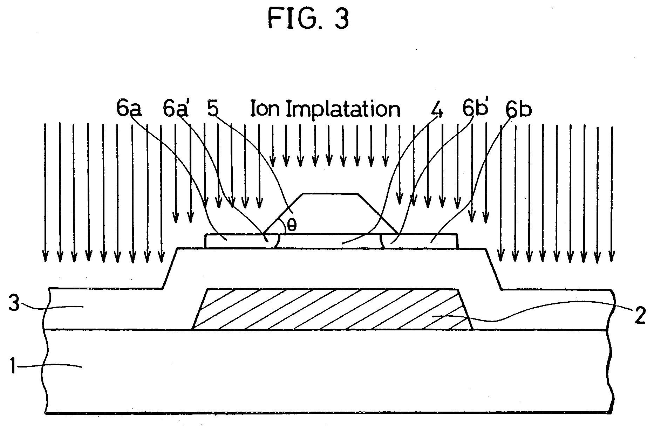

More specifically, as shown in Fig. 3, the semiconductor layer 4' having a thickness of 200 to 2,000 Å is deposited by for example, a plasma CVD method and patterned and then the channel protective layer 5 having a thickness of 1,000 to 3,000 Å and comprising $SiN_x$, $SiO_2$ or the like is formed on the semiconductor layer 4' in the same manner as the above.

When the protective layer is formed, a side surface of a resist is inclined by lowering a baking temperature of the resist and the side surface of the channel protective film 5 is inclined by etching the channel protective film 5 while the side surface of the resist retreats by dry etching. At this time, an etching selection ratio of the channel protective film and the semiconductor layer has a sufficiently large range. In addition, in a case of wet etching, a resist pattern is formed by a normal photolithography and etched away using BHF or the like, whereby a taper can be easily provided.

An angle of inclination $\Theta$ of the side surface of the channel protective film 5 having a cone-shaped section (trapezoid in this example) in which an upper side is shorter than a lower side as shown in Fig. 3 is preferably less than 90° or desirably ranges 10 to 50°. More specifically, the angle of inclination may be set so that an impurity can be implanted into a layer under the channel protective film 5 because a lower part of the protective film is thin by its inclination.

Then, an impurity of Group (V) element such as $P^+$, $PH^+$, $PH_2^+$, $B^+$, $As^-$ or their compound or Group (III) element or their compound is implanted into the semiconductor layer 4' by ion implantation with an accelerating voltage of 1 to 100keV, desirably 5 to 50 keV. At this time, the impurity is implanted with high concentration into a part of the semiconductor layer 4' which is not covered with the channel protective film 5 and then the contact layers 6a and 6b are formed. Meanwhile, the impurity is implanted with low concentration into a part of the semiconductor layer 4' which is covered with the inclined side surface of the channel protective film 5 and then the contact layers 6a' and 6b' are formed. At the same time, the semiconductor layer 4 into which the impurity is not implanted is formed under the center of the channel protective film 5.

Then, a source electrode 7 and a drain electrode 8 are formed thereon. Each electrode has one end put on the channel protective film 5. The electrodes are 2,000 to 4,000 Å in thickness and comprise Ti, Al, Mo, Cr or the like.

In addition, a pixel electrode 9 is formed so as to be in electrically contact with the drain electrode 8. The pixel electrode 9 comprises an indium tin oxide (ITO) or zinc oxide (ZnO) film in a case of a transparent type or comprises thallium (Ta), molybdenum (Mo), aluminum (Al) or titanium (Ti) film in a case of a reflection type and has a thickness of 500 to 1,000 Å.

Since the thin film transistor is structured as described above, there are contact layers 6a' and 6b' in which the impurity is implanted with low concentration under the channel protective film 5 as shown in Fig. 2. Therefore, the semiconductor layer 4 and the source electrode 7, and the semiconductor layer 4 and the drain electrode 8 are separated by the contact layers 6a' and 6b' in which the impurity is implanted with low concentration, respectively, whereby a leak current can be prevented from being generated between the source electrode 7 and the drain electrode 8.

In addition, although the contact layer is also formed under the side surface of the channel protective film 5 by an ion implantation method in the above embodiment of the present invention, the present invention is not limited to this method and the contact layer may be formed at the same place by another method.

EXAMPLE

A thin film transistor was manufactured in accordance with the structure and the manufacturing method as described above.

According to this embodiment of the present invention, glass (CORNING 7059) was used as the transparent insulating substrate 1 which was approximately 1.1mm in thickness. The gate electrode 2 comprising single-phase metal such as Ta was formed by a thickness of approximately 1200 Å on the substrate 1 by sputtering and then patterned. At the same time, the gate bus line 2a having the gate electrode 2 and diverging midway was formed.

In addition, the gate insulating film 3 and the semiconductor layer 4' were formed. More specifically, the gate insulating film was formed by depositing $SiN_x$ by a thickness of approximately 3000A by a plasma CVD method. The semiconductor layer 4' was formed of amorphous silicon to be an n type semiconductor by implanting P ions. In addition, the channel protective film 5 was deposited on the semiconductor layer 4'. The channel protective film 5 was formed of $Sin_x$ and its thickness was approximately 2,000 Å and an angle of inclination $\Theta$ on the side surface was approximately 30°. Then, P ions were implanted from the above with an accelerating voltage of approximately 30keV. A part of the semiconductor layer 4' which was not covered with the channel protective film 5 was implanted with ions with high concentration and became contact layers 6a and 6b having an ion concentration of approximately $5 \times 10^{15}/cm^2$.

Meanwhile, since a part just under the center of the channel protective film 5 was not implanted with ions, it was still the n type semiconductor layer and its ion concentration was less than $5 \times 10^{15}/cm^2$. The contact layers 6a' and 6b' in which ions were implanted with low concentration existed therebetween.

Then, the source electrode 7 and the drain electrode 8 were formed on the substrate 1 such that one end of each of the electrodes was on the channel protective film 5. The source electrode 7 and the drain electrode 8 was formed of Mo and were approximately 2,000 Å in thickness. Then, the pixel electrode 9 were formed on the substrate 1 so as to be connected to the drain electrode 8. The pixel electrode 9 was formed of ITO and was approximately 1,000 Å in thickness.

As described above, according to the thin film transistor of the present invention, since the contact layer in which the impurity is implanted with low concentration exists under the side surface of the channel protective film, a leak current generated between the source electrode and the drain electrode can be reduced by one or two figures. As a result, the leak current can be prevented from being generated. In addition, by using the manufacturing method of the present invention, the thin film transistor of the above structure can be formed without increasing the number of processing or the number of photomasks. As a result, it can be applied to an active matrix type display which requires a large current flow.

While only certain presently preferred embodiments have been described in detail, as will be apparent with those skilled in the art, certain changes and modifications can be made without departing from the scope of the invention as defined by the following claims.

**Claims**

1. A thin film transistor comprising:
    a gate electrode formed on a substrate;
    a gate insulating film covering said gate electrode;
    a semiconductor layer forming a channel region on said gate insulating film;
    a channel protective layer formed on the semiconductor layer in the vicinity of the center thereof; and
    a drain electrode and a source electrode extending in the right and left directions along said semiconductor layer surface from the right and left sides of said channel protective layer, respectively,
    wherein said channel protective layer has inclined right and left side surfaces, and the semiconductor layer is in contact with said source and drain electrodes and is doped with an impurity just under the foot of the inclined side surfaces of said channel protective layer in order to prevent a leak and to provide ohmic contact.

2.  A thin film transistor according to claim 1, wherein an angle of inclination formed by a inclined side surface of the channel protective layer and the semiconductor layer ranges 10 to 50°.

3.  A thin film transistor according to claim 1 wherein a thickness of the channel protective layer ranges 1000 to 3,000 Å.

4.  A thin film transistor according to claim 1, wherein the channel protective layer is formed of $SiN_x$ or $SiO_2$.

5.  A thin film transistor according to claim 1, wherein it is adopted to a liquid crystal display.

6.  A method for manufacturing a thin film transistor comprising the steps of:
    forming a gate electrode on a substrate, a gate insulating film covering said gate electrode, a semiconductor layer on said gate insulating film so that a channel region is formed, and a cone-shaped channel protective layer on the semiconductor layer in the vicinity of the center thereof, the protective layer comprising inclined right and left side surfaces;
    forming an ion doped region in the exposed semiconductor layer and the semiconductor layer just under the foot of the inclined side surface by ion implantation of an impurity in order to provide ohmic contact; and
    forming a drain electrode and a source electrode extending in the right and left directions along the exposed semiconductor layer from the right and left sides of said channel protective layer, respectively.

7.  A method for manufacturing a thin film transistor according to claim 6, wherein an accelerating voltage of ion implantation of an impurity ranges from 1 to 100 keV.

8.  A method of forming first and second contact regions (6a, 6b) in spaced apart portions of a semiconductor layer (4) by an ion doping operation, said regions being separated by a protective layer (5) acting as a mask during ion doping, characterised in that said protective layer is formed so as to have inclined side surfaces adjacent to said regions whereby ion doping is effected not only in fully exposed parts of the semiconductor layer adjacent said protective layer (5), but also in portions (6a', 6b') lying immediately beneath the foot of each of said inclined side surfaces.

## FIG. 1

FIG. 2

# FIG. 3

6a  6a'  5   Ion Implatation    4  6b'  6b

θ

EP 0 519 692 A2

3

2

1

FIG. 4

# FIG. 5

EP 0 519 692 A2

FIG. 6